(19) Europäisches Patentamt
European Patent Office
Office européen des brevets

(11) **EP 3 882 489 A1**

(12) **EUROPEAN PATENT APPLICATION**
published in accordance with Art. 153(4) EPC

(43) Date of publication:
**22.09.2021 Bulletin 2021/38**

(51) Int Cl.:
***F16H 55/08*** (2006.01)

(21) Application number: **19903202.0**

(22) Date of filing: **20.02.2019**

(86) International application number:
**PCT/CN2019/075539**

(87) International publication number:
**WO 2020/133650 (02.07.2020 Gazette 2020/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.12.2018 CN 201811616387**

(71) Applicant: **Chongqing University**
**Shapingba, Chongqing 400000 (CN)**

(72) Inventors:
• **CHEN, Bingkui**
**Chongqing 400000 (CN)**
• **ZHANG, Luhe**
**Chongqing 400000 (CN)**
• **PENG, Shuai**
**Chongqing 400000 (CN)**
• **LI, Chaoyang**
**Chongqing 400000 (CN)**
• **AN, Laiqiang**
**Chongqing 400000 (CN)**

(74) Representative: **Mammel und Maser**
**Patentanwälte**
**Tilsiter Straße 3**
**71065 Sindelfingen (DE)**

Remarks:
The applicant has filed figure 7 with which it is intended to bring the translation into conformity with the application as filed (Art. 14(2) EPC).

(54) **LINE-SURFACE CONJUGATION-BASED PAIRED GEAR MESHING PAIR AND DESIGN METHOD THEREFOR**

(57) A line-surface conjugation gear pair, comprising a first gear and a second gear. The first gear and the second gear form the line-surface conjugation gear pair. The line-surface conjugation gear pair comprises a curved surface $\Sigma 1$ and a curve $\Gamma 1$ that are in continuous tangential contact. The curved surface $\Sigma 1$ is located on the first gear, and only one curve on the curved surface $\Sigma 1$ is in contact with the curve $\Gamma 1$. The curve $\Gamma 1$ and the curved surface $\Sigma 1$ keep in point contact at a predetermined timing, and the contact point between the curve $\Gamma 1$ and the curved surface $\Sigma 1$ is unique. The curve $\Gamma 1$ is a smooth curve, and the curved surface $\Sigma 1$ is a smooth curved surface. Also disclosed is a design method for a line-surface conjugation gear pair.

Second Gear

Contact Point

First Gear

FIG. 1

**Description**

**Cross-Reference to Related Applications**

The present disclosure claims priority to Chinese Patent Application No. CN201811616387.8, filed with the Chinese Patent Office on December 27, 2018, entitled "Geometric Elements Constructed Tooth Pair based on Curve-Surface Conjugation and Method for Designing the Same", the contents of which is incorporated herein by reference in its entirety.

**Technical Field**

The present disclosure relates to the technical field of gear transmission devices, and in particular to geometric elements constructed tooth pair based on curve-surface (line-surface) conjugation (i.e. line-surface conjugation-based paired gear meshing pair) and a method for designing the same.

**Background Art**

As a typical basic mechanical part, the gear determines the performance of the equipment to a large extent, thus the design of high-performance gear transmission elements is also of extremely great significance and engineering practical value.

Among the prior cylindrical tooth pairs, the involute gear is the most widely used. The conjugation of an involute tooth pair is between surfaces, the contact between two surfaces forms a linear contact, and the tooth profile thereof is an involute. The involute gear has the advantage of separability of the center distance, but cannot cope with the axis skew or pitch error of the gear, and the gears brought into linear contact have a higher rate of sliding, which has an adverse effect on the wear of the tooth surface, the transmission efficiency, and the lifetime of the gear.

Based on the above problems, an involute gear transmission device curve-surface conjugation is proposed. Such gear has a small rate of sliding and can achieve a convex-concave form contact between tooth surfaces, and the gear has a strong bearing capability, but the involute gear transmission device of curve-surface conjugation is still established based on the involute, there are still some limitations on the tooth profile thereof, and moreover the problems of the axis deviation and pitch error of the gear cannot be solved.

**Summary**

An object of the present disclosure is to provide a geometric elements constructed tooth pair based on curve-surface conjugation to solve the technical problem existing in the prior art that the involute gear transmission device of curve-surface conjugation is established based on the involute, the tooth profile has some limitations, and the technical problems of axis deviation and pitch error of the gear cannot be solved.

The present disclosure also provides a method for designing a geometric elements constructed tooth pair based on curve-surface conjugation to solve the technical problem existing in the prior art that the involute gear transmission device of curve-surface conjugation is established based on the involute, the tooth profile has some limitations, and the axis deviation and pitch error of the gear cannot be solved.

The present provides a geometric elements constructed tooth pair based on curve-surface conjugation, comprising a first gear and a second gear, wherein the first gear and the second gear form a gear pair of curve-surface conjugation;

the gear pair of curve-surface conjugation comprises a curved surface $\Sigma_1$ and a curve $\Gamma_1$ which are in continuous tangential contact, wherein the curved surface $\Sigma_1$ is located on the first gear, and only one curve on the curved surface $\Sigma_1$ is in contact with the curve $\Gamma_1$; at a predetermined time, the curve $\Gamma_1$ is kept into point contact with the curved surface $\Sigma_1$, and at the predetermined time, the curve $\Gamma_1$ and the curved surface $\Sigma_1$ have a unique contact point; and
the curve $\Gamma_1$ is smooth, and the curved surface $\Sigma_1$ is smooth.

The present disclosure provides a method for designing a geometric elements constructed tooth pair based on curve-surface conjugation, comprising following steps of:

i) determining an equation of a curved surface $\Sigma_1$ of a first gear as:

$$\begin{cases} X_{\Sigma 1} = \mathrm{X(u,v)} \\ Y_{\Sigma 1} = \mathrm{Y(u,v)} \\ Z_{\Sigma 1} = \mathrm{Z(u,v)} \end{cases}$$

where u and v are parameters of the curved surface;

ii) determining an equation of a contact trace $\Gamma_2$ on a tooth surface of the first gear as:

$$\begin{cases} X_{r2} = \mathrm{X(u(\varphi), v(\varphi))} \\ Y_{r2} = \mathrm{Y(u(\varphi), v(\varphi))} \\ Z_{r2} = \mathrm{Z(u(\varphi), v(\varphi))} \end{cases}$$

where $\varphi$ is a spatial parameter;

iii) determining a normal vector $n_2^{12}(\ n_{x2}\ ,\ n_{y2}\ ,\ n_{z2}\ )$ of the contact trace on the tooth surface of the first gear as:

$$\begin{cases} n_{x2} = \frac{\partial(y_2, z_2)}{\partial(u,v)} |_{u(\varphi), v(\varphi)} \\ n_{y2} = \frac{\partial(z_2, x_2)}{\partial(u,v)} |_{u(\varphi), v(\varphi)} ; \\ n_{z2} = \frac{\partial(x_2, y_2)}{\partial(u,v)} |_{u(\varphi), v(\varphi)} \end{cases}$$

iv) determining a meshing equation of a curve $\Gamma_1$ and the curved surface $\Sigma_1$ based on a formula $n \cdot v^{(12)} = 0$;

$$\begin{cases} \Gamma_1^2(\varphi_1\ ,\ \varphi_2) = M_{12}(\varphi_2)\Gamma_2^2(\varphi) \\ f(\varphi_1\ ,\ \varphi_2) = v_2^{(12)} \cdot n_2^{12} = 0 \end{cases}$$

v) determining a conjugate curve according to an equation of the contact trace $\Gamma_2$ in a fixed coordinate system $S_1$ and the meshing equation; and

vi) determining an equation of a tooth surface $\Sigma_2$ of a second gear according to the conjugate curve.

Further, the step v further comprises steps of:

establishing the fixed coordinate system $S_1$ and a moving coordinate system $S_2$, wherein the fixed coordinate system $S_1$ and the moving coordinate system $S_2$ are fixedly associated with the curve $\Gamma_1$ and the curved surface $\Sigma_1$, respectively; and

determining a transformation matrix between the moving coordinate system $S_2$ and the fixed coordinate system $S_1$ as:

$$M_{12(\varphi_2)} = \begin{bmatrix} \cos(\varphi_1 - \varphi_2) & \sin(\varphi_1 - \varphi_2) & 0 & -a\cos\varphi_1 \\ -\sin(\varphi_1 - \varphi_2) & \cos(\varphi_1 - \varphi_2) & 0 & a\sin\varphi_1 \\ 0 & 0 & 1 & 0 \\ 0 & 0 & 0 & 1 \end{bmatrix}$$

where $\varphi_1$ is an angle by which the curve $\Gamma_1$ is rotated, and $\varphi_2$ is an angle by which the curved surface $\Sigma_1$ is rotated.

Further, the step iv further comprises:

determining a relative movement velocity $v^{(12)}$ of the moving coordinate system $S_2$ with respect to the fixed coordinate system $S_1$ as:

$$\begin{cases} v_x^{12} = \omega_2 y_2 - \omega_1 (y_2 + a\sin\varphi_2) \\ v_y^{12} = \omega_1 (x_2 - a\cos\varphi_2) - \omega_2 x_2 \\ \qquad\qquad v_z^{12} = 0 \end{cases}$$

where $\omega_1$ is an angular velocity at which the curve $\Gamma_1$ is rotated, and $\omega_2$ is an angular velocity at which the curved surface $\Sigma_1$ is rotated.

Further, the step vi further comprises:

selecting a curve of a normal section as $\Gamma_c$:

$$\Gamma_{(t)} = (\begin{array}{cccc} x(t) & 0 & z(t) & 1 \end{array})^{T_r},$$

where x(t) and z(t) are functions of a parameter t;

the $\Gamma_c$ is located on a normal plane of the curve $\Gamma_1$ and intersects with the curve $\Gamma_1$ at a point, and the curve $\Gamma_c$ passes the intersection point and a principle normal vector direction of the curve $\Gamma_c$ at the intersection point is consistent with a principle normal direction of the curved surface $\Sigma_1$ at the intersection point;

determining the equation of the tooth surface $\Sigma_2$ as follows: s $(\varphi, t) = M_C\Gamma(t)$,

$$M_C = \begin{bmatrix} \beta_1^2 \cdot i_1 & \alpha_1^2 \cdot i_1 & \gamma_1^2 \cdot i_1 & \\ \beta_1^2 \cdot j_1 & \alpha_1^2 \cdot j_1 & \gamma_1^2 \cdot j_1 & \Gamma_1^2 \\ \beta_1^2 \cdot k_1 & \alpha_1^2 \cdot k_1 & \gamma_1^2 \cdot k_1 & \end{bmatrix}$$

where $\beta_1^2$ is a principle normal vector of the curved surface $\Sigma_2$ at the intersection point, $\alpha_1^2$ is a vector tangent to the contact trace $\Gamma_2$ on the curved surface $\Sigma_2$ at the contact point, and $\gamma_1^2$ is obtained by $\beta_1^2 \times \alpha_1^2$.

In the geometric elements constructed tooth pair based on curve-surface conjugation according to the present disclosure, the first gear and the second gear form a gear pair of curve-surface conjugation, the first gear has a tooth profile remaining unchanged, the curved surface $\Sigma_1$ is located on the first gear, and only one curve on the curved surface $\Sigma 1$ is in contact with the curve $\Gamma_1$; at each time t, the curve $\Gamma_1$ is kept into point contact with the curved surface $\Sigma_1$, and each point of the curved surface $\Sigma_1$ is brought into contact at a unique time t, that is to say, the curve $\Gamma_1$ and the curved surface $\Sigma_1$ have a unique contact point; the curve $\Gamma_1$ is smooth, and the curved surface $\Sigma_1$ is smooth, such that the curve-surface conjugation of the geometric elements constructed tooth pair is achieved.

In the method for designing a geometric elements constructed tooth pair based on curve-surface conjugation according to the present disclosure, an equation of a curved surface $\Sigma_1$ of a first gear is firstly determined according to the known first gear; then an equation of the contact trace $\Gamma_2$ on the tooth surface of the first gear is determined; a normal vector $n_2^{12}$ of the contact trace is determined according to the equation of the contact trace $\Gamma_2$; then a meshing equation of the curve $\Gamma_1$ and the curved surface $\Sigma_1$ is determined based on the formula n· $v^{(12)}$ = 0; a conjugate curve is determined according to an equation of the contact trace $\Gamma_2$ in a fixed coordinate system $S_1$ and the meshing equation; and an equation of a tooth surface $\Sigma_2$ of a second gear is determined according to the conjugate curve, such that the determination of the equation of the tooth surface of the second gear is achieved. The first gear and the second gear are brought into contact on the theoretical basis of curve-surface meshing, which has the characteristics of strong adaptability to the axis skew and pitch error of the gear and the separability of the center distance, and moreover, the actual contact between the first gear and the second gear is in a point contact state, and approximately theoretically pure rolling occurs between the tooth surfaces with a small rate of sliding; and the type of contact between the tooth surfaces is not limited to the convex-convex contact, or may also be convex-concave contact, and the present disclosure is applicable over a wide range and can improve the bearing capacity of the gears.

**Brief Description of Drawings**

In order to more clearly illustrate technical solutions of specific embodiments of the present disclosure or of the prior art, drawings required for use in the description of the specific embodiments or the prior art will be described briefly below. It is apparent that the drawings in the following description are merely illustrative of some embodiments of the present disclosure. It will be understood by those of ordinary skill in the art that other drawings can also be obtained from these drawings without any inventive effort.

FIG. 1 is a schematic diagram showing selection of a contact trace $\Gamma_2$ in a method for designing a geometric elements constructed tooth pair based on curve-surface conjugation according to an embodiment of the present disclosure;

FIG. 2 is a schematic diagram showing selection of a contact trace $\Gamma_2$ in a method for designing a geometric elements constructed tooth pair based on curve-surface conjugation according to a first embodiment of the present disclosure;

FIG. 3 is a schematic diagram showing simulation of a contact trace $\Gamma_2$ in a method for designing a geometric elements constructed tooth pair based on curve-surface conjugation according to the first embodiment of the present disclosure;

FIG. 4 is a schematic diagram showing a normal direction of a contact trace $\Gamma_2$ in a method for designing a geometric elements constructed tooth pair based on curve-surface conjugation according to an embodiment of the present disclosure;

FIG. 5(a) is a first schematic diagram showing a normal direction of a contact trace $\Gamma_2$ in a method for designing a geometric elements constructed tooth pair based on curve-surface conjugation according to an embodiment of the present disclosure;

FIG. 5(b) is a second schematic diagram showing a normal direction of a contact trace $\Gamma_2$ in a method for designing a geometric elements constructed tooth pair based on curve-surface conjugation according to an embodiment of the present disclosure;

FIG. 6 shows a spatial coordinate system in a method for designing a geometric elements constructed tooth pair based on curve-surface conjugation according to an embodiment of the present disclosure;

FIG. 7 shows a spatial coordinate system for a relative movement velocity in a method for designing a geometric elements constructed tooth pair based on curve-surface conjugation according to an embodiment of the present disclosure;

FIG. 8 is a schematic diagram showing a conjugate curve in a method for designing a geometric elements constructed tooth pair based on curve-surface conjugation according to a first embodiment of the present disclosure;

FIG. 9 is a schematic diagram showing a meshing line in a method for designing a geometric elements constructed tooth pair based on curve-surface conjugation according to an embodiment of the present disclosure;

FIG. 10 is a simulated schematic diagram showing a structural diagram of a tooth surface in a method for designing a geometric elements constructed tooth pair based on curve-surface conjugation according to the first embodiment of the present disclosure;

FIG. 11(a) is a first emulational schematic diagram showing a structural diagram of a tooth surface in a method for designing a geometric elements constructed tooth pair based on curve-surface conjugation according to the first embodiment of the present disclosure;

FIG. 11(b) is a second emulational schematic diagram showing a structural diagram of a tooth surface in a method for designing a geometric elements constructed tooth pair based on curve-surface conjugation according to the first embodiment of the present disclosure;

FIG. 11(c) is a third emulational schematic diagram showing a structural diagram of a tooth surface in a method for designing a geometric elements constructed tooth pair based on curve-surface conjugation according to the first embodiment of the present disclosure;

FIG. 12 is a model schematic diagram of a pinion gear of a geometric elements constructed tooth pair based on curve-surface conjugation according to the first embodiment of the present disclosure;

FIG. 13 is a structural schematic diagram showing an envelope method for solving a tooth profile equation in a method for designing a geometric elements constructed tooth pair based on curve-surface conjugation according to a second embodiment of the present disclosure;

FIG. 14 is a structural schematic diagram showing a tooth profile normal method for solving a tooth profile equation in a method for designing a geometric elements constructed tooth pair based on curve-surface conjugation according to a third embodiment of the present disclosure; and

Table 1 shows parameters of the gear pair.

**Detailed Description of Embodiments**

The technical solutions of the present disclosure will be described below clearly and completely in connection with the drawings. It is apparent that the embodiments to be described are some, but not all of the embodiments of the present disclosure. All the other embodiments obtained by those of ordinary skill in the art in light of the embodiments of the present disclosure without inventive efforts shall fall within the scope of the present disclosure as claimed.

In the description of the present disclosure, it should be noted that orientation or positional relations indicated by the terms such as "center", "up", "down", "left", "right", "vertical", "horizontal", "inside", or "outside", if present, are the orientation or positional relations shown based on the figures, and these terms are intended only to facilitate the description of the present disclosure and to simplify the description, rather than indicating or implying that the referred devices or elements must be in a particular orientation or constructed or operated in the particular orientation, and therefore should not be construed as limiting the present disclosure. In addition, the term "first", "second", or "third", if present, is used for descriptive purpose only, and should not be understood as an indication or implication of relative importance.

In the description of the present disclosure, it should be noted that the term "mount", "couple", or "connect", if present, should be understood broadly unless otherwise expressly specified or defined. For example, a connection may be fixed connection or detachable connection or integral connection, may be mechanical connection or electric connection, or may be direct coupling or indirect coupling via an intermediate medium or internal communication between two elements. The specific meanings of the above-mentioned terms in the present disclosure can be understood by those of ordinary skill in the art according to specific situations.

The present disclosure provides a geometric elements constructed tooth pair (gear meshing pair) based on curve-surface conjugation, the geometric elements constructed tooth pair based on curve-surface conjugation comprising a first gear and a second gear, wherein the first gear and the second gear form a gear pair of curve-surface conjugation, and the first gear has a tooth profile remaining unchanged; the gear pair of curve-surface conjugation comprises a curved surface $\Sigma_1$ and a curve $\Gamma_1$ which are in continuous tangential contact, the curved surface $\Sigma_1$ is located on the first gear, and only one curve on the curved surface $\Sigma_1$ is in contact with the curve $\Gamma_1$; at a predetermined time, the curve $\Gamma_1$ is kept into point contact with the curved surface $\Sigma_1$, and at the predetermined time, the curve $\Gamma1$ and the curved surface $\Sigma_1$ have a unique contact point; the curve $\Gamma_1$ is smooth, and the curved surface $\Sigma_1$ is smooth.

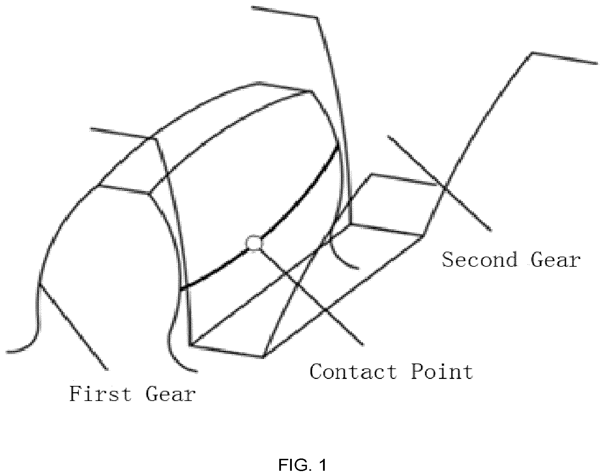

In the geometric elements constructed tooth pair based on curve-surface conjugation according to the present disclosure, as shown in FIG. 1, the first gear and the second gear form a gear pair of curve-surface conjugation, the curved surface $\Sigma_1$ is located on the first gear, and only one curve on the curved surface $\Sigma_1$ is in contact with the curve $\Gamma_1$; at each time t, the curve $\Gamma_1$ is kept into point contact with the curved surface $\Sigma_1$, and each point of the curved surface $\Sigma_1$ is brought into contact at a unique time t, that is to say, the curve $\Gamma_1$ and the curved surface $\Sigma_1$ have a unique contact point; the curve $\Gamma_1$ is smooth, and the curved surface $\Sigma_1$ is smooth, such that the curve-surface conjugation of the geometric elements constructed tooth pair is achieved.

**First Embodiment**

The present disclosure provides a method for designing a geometric elements constructed tooth pair based on curve-surface conjugation, the method for designing a geometric elements constructed tooth pair based on curve-surface conjugation comprising the following steps of: i) determining an equation of a curved surface $\Sigma_1$ of a first gear

as: $\begin{cases} X_{\Sigma 1} = \mathrm{X}(\mathrm{u}, \mathrm{v}) \\ Y_{\Sigma 1} = \mathrm{Y}(\mathrm{u}, \mathrm{v}) \\ Z_{\Sigma 1} = \mathrm{Z}(\mathrm{u}, \mathrm{v}) \end{cases}$ ,   where u and v are parameters of the curved surface; ii) determining an equation of a contact

$$\begin{cases} X_{r2} = X(u(\varphi), v(\varphi)) \\ Y_{r2} = Y(u(\varphi), v(\varphi)) \\ Z_{r2} = Z(u(\varphi), v(\varphi)) \end{cases},$$

trace $\Gamma_2$ on a tooth surface of the first gear as: where $\varphi$ is a spatial parameter; iii) determining a normal vector $n_2^{12}\ (\ n_{x2}\ ,\ n_{y2}\ ,\ n_{z2}\ )$ of the contact trace on the tooth surface of the first gear as:

$$\begin{cases} n_{x2} = \frac{\partial(y_2, z_2)}{\partial(u,v)}\big|_{u(\varphi), v(\varphi)} \\ n_{y2} = \frac{\partial(z_2, x_2)}{\partial(u,v)}\big|_{u(\varphi), v(\varphi)}; \text{ iv)} \\ n_{z2} = \frac{\partial(x_2, y_2)}{\partial(u,v)}\big|_{u(\varphi), v(\varphi)} \end{cases}$$

determining a meshing equation of a curve $\Gamma_1$ and the curved surface $\Sigma_1$ based on a

$$\begin{cases} \Gamma_1^2\left(\varphi_1\ ,\ \varphi_2\right) = M_{12}(\varphi_2)\Gamma_2^2(\varphi) \\ f\left(\varphi_1\ ,\ \varphi_2\right) = v_2^{(12)} \cdot n_2^{12} = 0 \end{cases}$$

formula n· $v^{(12)}$ = 0 ; v) determining a conjugate curve according to an equation of the contact trace $\Gamma_2$ in a fixed coordinate system $S_1$ and the meshing equation; and vi) determining an equation of a tooth surface $\Sigma_2$ of a second gear according to the conjugate curve.

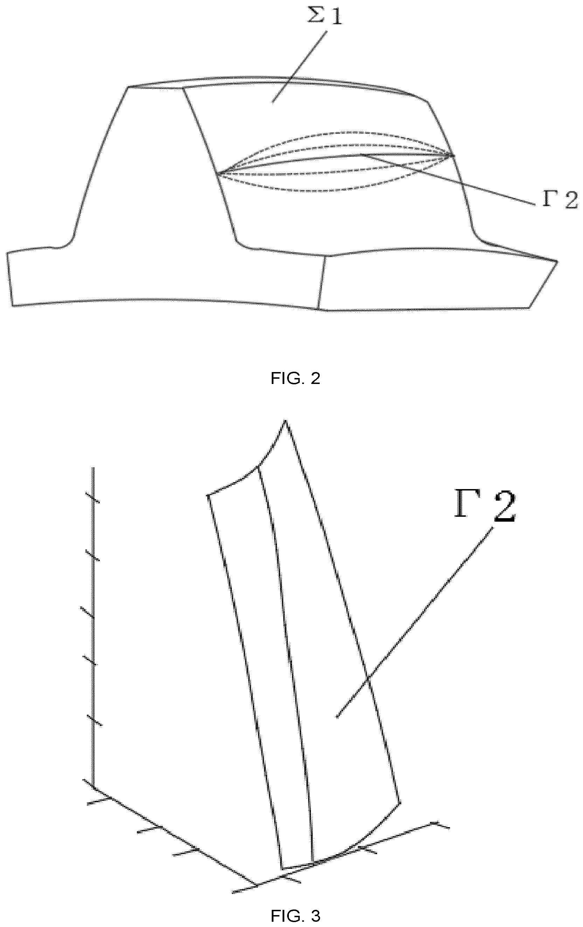

In the present disclosure, an internal meshing gear is taken as an example. As shown in FIG. 2, the first gear is known as an internal meshing gear, and a tooth profile of an internally-meshing end surface has an involute at one end, and the equation thereof can be expressed as:

$$\begin{cases} x_{d2} = r\cos\theta + r\theta\sin\theta \\ y_{d2} = r\sin\theta - r\theta\cos\theta \\ z_{d2} = 0 \end{cases}$$

where r is the radius of a base circle, and $\theta$ is an involute parameter.

A tooth surface of a bevel gear can be obtained by the same helical motion of each point on the involute about a z-axis which is a rotating shaft, i.e., rotating about the z-axis at a constant speed while performing a linear motion along the z-axis at a constant speed. Therefore, the equation of the tooth surface of the internal gear can be expressed as:

$$\begin{cases} x_{\Sigma 1} = x_{d2}\cos\alpha - y_{d2}\sin\alpha \\ y_{\Sigma 1} = x_{d2}\sin\alpha + y_{d2}\cos\alpha \\ z_{\Sigma 1} = z_{d2} + p\alpha \end{cases}$$

The two equations are combined to obtain the equation of the curved surface $\Sigma_1$:

$$\begin{cases} x_{\Sigma 1} = r\cos\left(\theta + \alpha\right) + r\theta\sin\left(\theta + \alpha\right) \\ y_{\Sigma 1} = r\sin(\theta + \alpha) - r\theta\cos\left(\theta + \alpha\right) \\ z_{\Sigma 1} = p\alpha \end{cases}$$

where a is an angle of rotation about the z-axis.

Then, the contact trace $\Gamma_2$ is selected on the first gear to determine the equation of $\Gamma_2$:

Specifically, the contact trajectory of the geometric elements constructed gear of curve-surface meshing may be selected as desired, that is to say, a smooth continuous curve is designated on the first gear as the contact trace. For an internal gear, an infinite number of curves may be selected on its tooth surface, and there are various selection methods. After a starting point and an ending point are determined on the curved surface $\Sigma_1$ of the first gear, a shortest curve can be determined. It is assumed that the parameters $\theta$ and a of the curved surface have the simplest linear relation therebetween:

$$\alpha = k\theta + b$$

where $k = \dfrac{B}{P(\theta_2 - \theta_1)}$, $b = -\dfrac{\theta_1 B}{P(\theta_2 - \theta_1)}$, B is a tooth width, p is a spiral parameter, $\theta$ is in the range of $\theta_1 \le \theta \le \theta_2$, and $\theta_1$ and $\theta_2$ are values of $\theta$ at the starting point and the ending point on the curved surface.

Therefore, the contact trace $\Gamma_2$ on the internal gear can be expressed as:

$$\Gamma_2^2 = \begin{cases} x_{r2} = r\cos(\theta + \alpha) + r\theta\sin(\theta + \alpha) \\ y_{r2} = r\sin(\theta + \alpha) - r\theta\cos(\theta + \alpha) \\ z_{r2} = p\alpha \\ \alpha = k\theta + b \end{cases}$$

As shown in FIG. 3, the contact trace is simulated in the software MATLAB. Unlike common bevel gears with point meshing, the meshing trace is not a cylindrical helix, but is a smooth curve from the bottom to the top of the tooth.

Then, $\Gamma_2^2$ is calculated in accordance with the formula

$$\begin{cases} n_{x2} = \frac{\partial(y_2, z_2)}{\partial(u,v)} \big|_{u(\varphi), v(\varphi)} \\ n_{y2} = \frac{\partial(z_2, x_2)}{\partial(u,v)} \big|_{u(\varphi), v(\varphi)} \cdot \\ n_{z2} = \frac{\partial(x_2, y_2)}{\partial(u,v)} \big|_{u(\varphi), v(\varphi)} \end{cases}$$

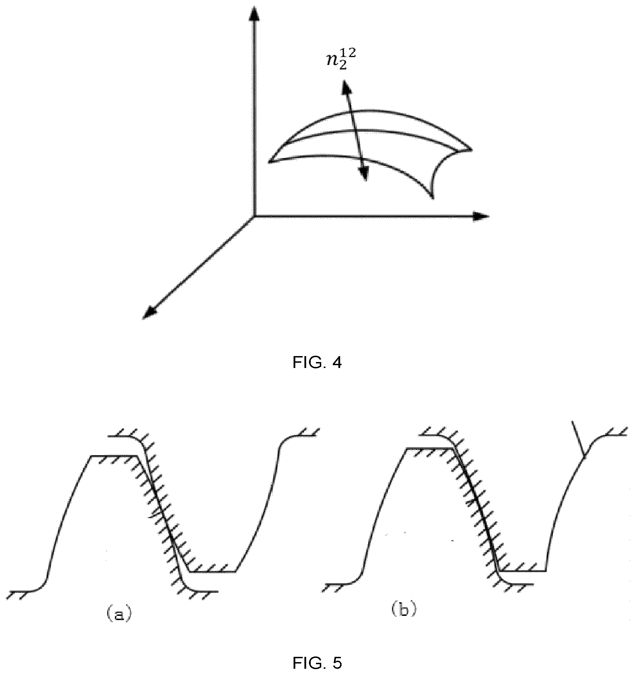

As shown in FIG. 4, the normal direction $n_2^{12}$ of the contact trace $\Gamma_2$ on the curved surface $\Sigma_1$ of the internal gear is determined as follows:

$$\begin{cases} n_{x2} = -pr\theta\sin[(k+1)\theta + b] \\ n_{y2} = pr\theta\cos[(k+1)\theta + b] \\ n_{z2} = -r^2\theta \end{cases}$$

It should be noted that for the obtained normal vector $n_2^{12}$, different directions represent different meshing forms. As shown in FIG. 5(a), when the normal vector $n_2^{12}$ points to a convex direction of the curved surface, the gear pair is constructed in an external meshing manner, and as shown in FIG. 5(b), when the normal vector $n_2^{12}$ points to a concave direction of the curved surface, the gear pair is constructed in an internal meshing manner.

Then, the meshing equation of the curve $\Gamma_1$ and the curved surface $\Sigma_1$ is determined according to the formula $n \cdot v^{(12)} = 0$.

Then, according to the formula

$$\begin{cases} \Gamma_1^2(\varphi_1, \varphi_2) = M_{12}(\varphi_2)\Gamma_2^2(\varphi) \\ f(\varphi_1, \varphi_2) = v_2^{(12)} \cdot n_2^{12} = 0 \end{cases}$$

a conjugate curve is determined.

Finally, the equation of the tooth surface $\Sigma_2$ of the second gear is determined according to the conjugate curve.

In the method for designing a geometric elements constructed tooth pair based on curve-surface conjugation according to the present disclosure, the first gear and the second gear are brought into contact on the theoretical basis of curve-surface meshing, which has the characteristics of strong adaptability to the axis skew and pitch error of the gear and the separability of the center distance, and moreover, the actual contact between the first gear and the second gear is in a point contact state, and approximately theoretically pure rolling occurs between the tooth surfaces with a small rate of sliding; and the type of contact between the tooth surfaces is not limited to the convex-convex contact, or may also be convex-concave contact, and the present disclosure is applicable over a wide range and can improve the bearing capacity of the gears.

Further, the step v further comprises the steps of: establishing a fixed coordinate system $S_1$ and a moving coordinate system $S_2$, wherein the fixed coordinate system $S_1$ and the moving coordinate system $S_2$ are fixedly associated with the curve $\Gamma_1$ and the curved surface $\Sigma_1$, respectively; and determining a transformation matrix between the moving coordinate system $S_2$ and the fixed coordinate system $S_1$ as: $M_{12(\varphi_2)} =$

$$
\begin{bmatrix}
\cos(\varphi_1 - \varphi_2) & \sin(\varphi_1 - \varphi_2) & 0 & -a\cos\varphi_1 \\
-\sin(\varphi_1 - \varphi_2) & \cos(\varphi_1 - \varphi_2) & 0 & a\sin\varphi_1 \\
0 & 0 & 1 & 0 \\
0 & 0 & 0 & 1
\end{bmatrix},
$$

where $\varphi_1$ is an angle by which the curve $\Gamma_1$ is rotated, and $\varphi_2$ is an angle by which the curved surface $\Sigma_1$ is rotated.

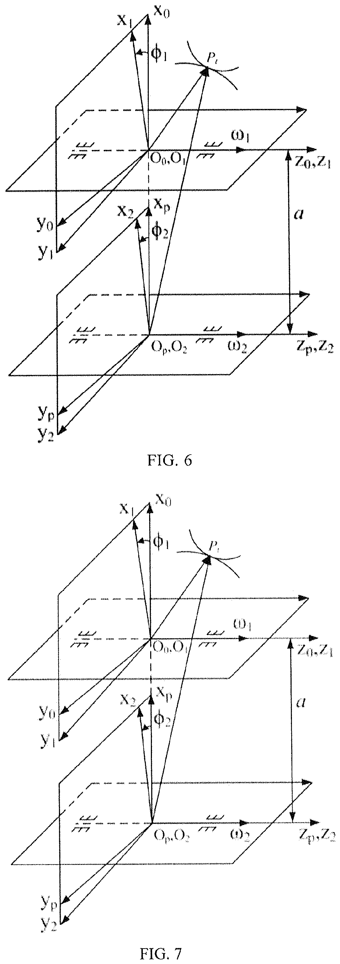

Specifically, in the step v, it is necessary to firstly establish the fixed coordinate system $S_1$ and the moving coordinate system $S_2$, wherein the fixed coordinate system $S_1$ and the moving coordinate system $S_2$ are fixedly associated with the curve $\Gamma_1$ and the curved surface $\Sigma_1$, respectively, as shown in FIG. 6, in which $S_o$ ( $O_o$ - $x_o$, $y_o$, $z_o$ ) and $S_p$ ( $O_p$ - $x_p$, $y_p$, $z_p$ ) are two spatially fixed coordinate systems, the z-axis coincides with the axis of rotation of the curve $\Gamma_1$, and the $Z_p$ axis coincides with the axis of rotation of the curved surface $\Sigma_1$. The x-axis coincides with the $x_p$ axis, and this direction is a direction in which the two axes have the shortest distance, i.e., center distance a. The fixed coordinate system $S_1$ ( $O_1$ - $x_1$, $y_1$, $z_1$ ) and the moving coordinate system $S_2$ ( $O_2$ - $x_2$, $y_2$, $z_2$ ) coincide with $S_o$ ( $O_o$ - $x_o$, $y_o$, $z_o$ ) and $S_p$ ( $O_p$ - $x_p$, $y_p$, $z_p$ ) at the starting position, respectively. The curve $\Gamma_1$ is rotated about the $z_0$ axis at an angular velocity $\omega_1$, and the curved surface $\Sigma_1$ is rotated about the $z_p$ axis at an angular velocity $\omega_2$. After a period of time has elapsed from the starting position, the curve $\Gamma_1$ is rotated by the angle $\varphi_1$, and the curved surface $\Sigma_1$ is rotated by the angle $\varphi_2$.

As shown in FIG. 6, the moving coordinate system $S_2$ and the fixed coordinate system $S_1$ have the following transformation relation:

$$
\begin{aligned}
M_{12} &= M_{10}M_{op}M_{p2} \\
&= \begin{bmatrix}
\cos\varphi_1 & \sin\varphi_1 & 0 & 0 \\
-\sin\varphi_1 & \cos\varphi_1 & 0 & 0 \\
0 & 0 & 1 & 0 \\
0 & 0 & 0 & 1
\end{bmatrix}
\begin{bmatrix}
1 & 0 & 0 & -a \\
0 & 1 & 0 & 0 \\
0 & 0 & 1 & 0 \\
0 & 0 & 0 & 1
\end{bmatrix}
\begin{bmatrix}
\cos\varphi_2 & -\sin\varphi_2 & 0 \\
\sin\varphi_2 & \cos\varphi_2 & 0 \\
0 & 0 & 1 \\
0 & 0 & 0
\end{bmatrix} \\
&= \begin{bmatrix}
\cos(\varphi_1 - \varphi_2) & \sin(\varphi_1 - \varphi_2) & 0 & -a\cos\varphi_1 \\
-\sin(\varphi_1 - \varphi_2) & \cos(\varphi_1 - \varphi_2) & 0 & a\sin\varphi_1 \\
0 & 0 & 1 & 0 \\
0 & 0 & 0 & 1
\end{bmatrix}
\end{aligned}
$$

Thus, an equation of the contact trace $\Gamma_2$ in the fixed coordinate system $S_1$ can be obtained according to the formula $\Gamma_1^2 (\varphi_1 , \varphi_2) = M_{12}(\varphi_2)\Gamma_2^2 (\varphi)$.

Further, the step iv further comprises: determining a relative movement velocity $v^{(12)}$ of the moving coordinate

$$
\begin{cases}
v_x^{12} = \omega_2 y_2 - \omega_1 ( y_2 + a\sin\varphi_2 ) \\
v_y^{12} = \omega_1 (x_2 - a\cos\varphi_2) - \omega_2 x_2 \\
v_z^{12} = 0
\end{cases},
$$

system S2 with respect to the fixed coordinate system $S_1$ as , where $\omega_1$ is an angular velocity at which the curve $\Gamma_1$ is rotated, and $\omega_2$ is an angular velocity at which the curved surface $\Sigma_1$ is rotated.

As shown in FIG. 7, in order to facilitate the vector operation, $i_2, j_2,$ and $k_2$ are respectively set as unit vectors of the coordinate axes $x_2, y_2,$ and $z_2$, and the point $P_t$ is set as an arbitrary contact point between the curve and the curved surface in the space, which has coordinate values $(x_2, y_2, z_2)$ in the coordinate system $S_2$; the respective angular velocities of the curve $\Gamma_1$ and the curved surface $\Sigma_1$ in the coordinate system $S_2$ are respectively expresses with vectors as

$$
\begin{cases}
\omega_1 = \omega_1 k_1 \\
\omega_2 = \omega_2 k_2
\end{cases}
$$

where $\omega_1$ is a modulus of the angular velocity of the curve $\Gamma_1$, and $\omega_2$ is a modulus of the angular velocity of the curved surface $\Sigma_1$.

As shown in FIG. 7, $r^1 = O_1P_t = O_1O_2 + O_2P_t = (x_2 - a\cos\varphi_2)i_2 + (a\sin\varphi_2 + y_2)j_2 + z_2k_2$

$$r^2 = O_2P_t = x_2i_2 + y_2\ j_2 + z_2k_2$$

The point $P_t$ has the following velocities in the coordinate system $So$ when moving with the curve $\Gamma_1$ and the curved surface $\Sigma_1$, respectively:

$$v_2^1 = \omega_1 \times r^1$$

$$v_2^1 = \omega_1 \times r^1$$

Meanwhile, the relative movement velocity of the curve $\Gamma_1$ and the curved surface $\Sigma_1$ at the point $P_t$ in the coordinate system $S_2$ can be expressed as:

$$v_1^{12} = v_2^1 - v_2^2$$

If it is written into

$$v_2^{12} = v_x^{12}i_2 + v_y^{12}\ j_2 + v_z^{12}k_2,$$

$$\begin{cases} v_x^{12} = \omega_2 y_2 - \omega_1\ (\ y_2 + a\sin\varphi_2\ ) \\ v_y^{12} = \omega_1(x_2 - a\cos\varphi_2) - \omega_2 x_2 \\ v_z^{12} = 0 \end{cases}$$

can be obtained as described above.

Thus, the following meshing equation is obtained based on the formula n· $v^{(12)}$ = 0:

$$i_{12}an_{x2}\sin(\varphi_2) +\ i_{12}an_{y2}\cos(\varphi_2) = (i_{12} - 1)(x_2n_{y2} - y_2n_{x2})$$

Supposing A = $i_{12}an_{x2}$, B = $i_{12}an_{y2}$, M = $(i_{12} - 1)$ $(x_2n_{y2} - y_2n_{x2})$, $i_{12}$ is a transmission ratio, and $\varphi_1 = i_{12}\varphi_2$, a simplified form of the meshing equation can be obtained as follows:

$$A\sin(\varphi_2) +\ B\cos(\varphi_2) = M$$

Then, the following conjugate curve is determined according to the equation of the contact trace $\Gamma_2$ in the fixed coordinate system $S_1$ and the meshing equation:

$$\begin{cases} x_{r1} = x_{r2}\cos((i_{12} - 1)\varphi_2) + y_{r2}\sin((i_{12} - 1)\varphi_2) - a\sin(i_{12}\varphi_2) \\ y_{r1} = -x_{r2}\sin((i_{12} - 1)\varphi_2) + y_{r2}\cos((i_{12} - 1)\varphi_2) + a\sin(i_{12}\varphi_2) \\ z_{r1} = z_{r2} \\ A\sin(\varphi_2) +\ B\cos(\varphi_2) = M \end{cases}$$

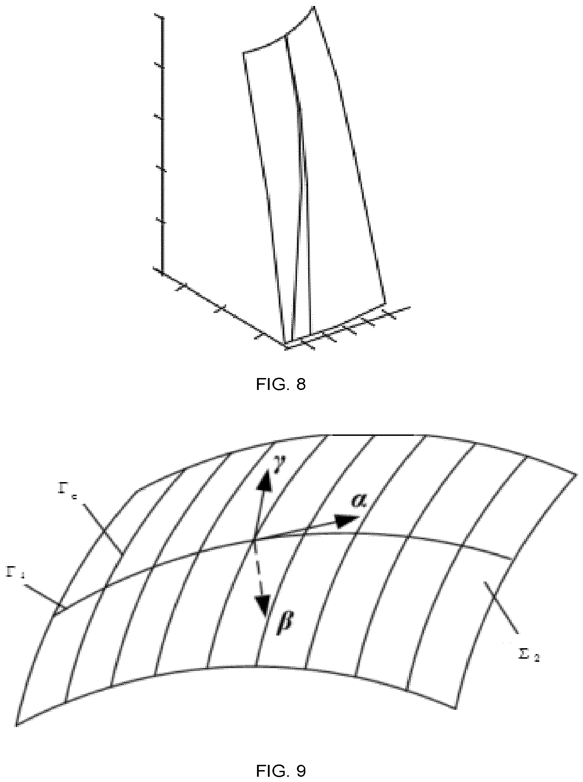

Then, the conjugate curve obtained in accordance with the above steps using MATLAB is shown in FIG. 8.

Further, the step vi further comprises: selecting a curve of a normal section as $\Gamma_c$ : $\Gamma_{(t)} = (x(t)\ 0\ z(t)\ 1)^{Tr}$, wherein $x(t)$ and $z(t)$ are functions of the parameter t; the $\Gamma_c$ is located on a normal plane of the curve $\Gamma_1$ and intersects with the curve $\Gamma_1$ at a point, and the curve $F_c$ passes the intersection point and a principle normal vector direction of the curve $\Gamma_c$ at the intersection point is consistent with a principle normal direction of the curved surface $\Sigma_1$ at the intersection

point; and determining the equation of the tooth surface $\Sigma_2$ as follows: S $(\varphi, t) = M_C\Gamma(t)$,

$$M_C = \begin{bmatrix} \beta_1^2 \cdot i_1 & \alpha_1^2 \cdot i_1 & \gamma_1^2 \cdot i_1 & \\ \beta_1^2 \cdot j_1 & \alpha_1^2 \cdot j_1 & \gamma_1^2 \cdot j_1 & \Gamma_1 \\ \beta_1^2 \cdot k_1 & \alpha_1^2 \cdot k_1 & \gamma_1^2 \cdot k_1 & \end{bmatrix}^2$$

, where $\beta_1^2$ is a principle normal vector of the curved surface $\Sigma_2$ at the intersection point, $\alpha_1^2$ is a vector tangent to the contact trace $\Gamma_2$ on the curved surface $\Sigma_2$ at the contact point, and $\gamma_1^2$ is obtained by $\beta_1^2 \times \alpha_1^2$.

In the first embodiment, the construction of the tooth surface of the second gear is carried out by using a normal section method.

Specifically, as shown in FIG. 9, the tooth surface of the second gear can be constructed by a continuous change of the normal section which is a curved surface along the conjugate curve. The normal section may be composed of any smooth curve. As can be obtained from the formula $\Gamma_{(t)} = (x(t)\ 0\ z(t)\ 1)^{Tr}$, the equation of the tooth profile of the normal section can be expressed as:

$$\Gamma_{(t)} = (x_c, y_c, z_c, 1)^{T_r} = (k_1 \cos(t) + k_1 \quad 0 \quad k_1 \sin(t) \quad 1)^{T_r}$$

where $k_1$ is the radius of a circular arc of the tooth surface.

According to the relation between vectors and the necessary matrix transformation, an equation expression of the normal vector $\beta$ can be calculated as follows:

$$\begin{cases} n_{x\beta2} = n_{x2}\cos[(i_{12}-1)\varphi_2] + n_{y2}\sin[(i_{12}-1)\varphi_2] \\ n_{y\beta2} = -n_{x2}\sin[(i_{12}-1)\varphi_2] + n_{y2}\cos[(i_{12}-1)\varphi_2] \\ n_{z\beta2} = n_{z2} \end{cases}$$

The tangent vector a can be expressed as

$$\begin{cases} n_{x\alpha2} = \dot{x}_{r2}\cos[(i_{12}-1)\varphi_2] + \dot{y}_{r2}\sin[(i_{12}-1)\varphi_2] \\ n_{y\alpha2} = -\dot{x}_{r2}\sin[(i_{12}-1)\varphi_2] + \dot{y}_{r2}\cos[(i_{12}-1)\varphi_2] \\ n_{z\alpha2} = \dot{z}_{r2} \end{cases}$$

A secondary normal vector y can be determined from the expression $\gamma=\alpha\times\beta$ to obtain:

$$\begin{cases} n_{xy2} = n_{y\beta2}n_{z\alpha2} - n_{y\alpha2}n_{z\beta2} \\ n_{yy2} = n_{z\beta2}n_{x\alpha2} - n_{z\alpha2}n_{x\beta2} \\ n_{zy2} = n_{x\beta2}n_{y\alpha2} - n_{x\alpha2}n_{y\beta2} \end{cases}$$

The unit vector thereof is obtained as follows:

$$\begin{cases} n_{nx\beta} = \dfrac{n_{x\beta2}}{\sqrt{n_{x\beta2}^2 + n_{y\beta2}^2 + n_{z\beta2}^2}} \\ \\ n_{ny\beta} = \dfrac{n_{y\beta2}}{\sqrt{n_{x\beta2}^2 + n_{y\beta2}^2 + n_{z\beta2}^2}} \\ \\ n_{nz\beta} = \dfrac{n_{z\beta2}}{\sqrt{n_{x\beta2}^2 + n_{y\beta2}^2 + n_{z\beta2}^2}} \end{cases}$$

$$\begin{cases} n_{nx\alpha} = \dfrac{n_{x\alpha2}}{\sqrt{n_{x\alpha2}^2 + n_{y\alpha2}^2 + n_{z\alpha2}^2}} \\[2mm] n_{ny\alpha} = \dfrac{n_{y\alpha2}}{\sqrt{n_{x\alpha2}^2 + n_{y\alpha2}^2 + n_{z\alpha2}^2}} \\[2mm] n_{nz\alpha} = \dfrac{n_{z\alpha2}}{\sqrt{n_{x\alpha2}^2 + n_{y\alpha2}^2 + n_{z\alpha2}^2}} \end{cases}$$

$$\begin{cases} n_{nx\gamma} = \dfrac{n_{x\gamma2}}{\sqrt{n_{x\gamma2}^2 + n_{y\gamma2}^2 + n_{z\gamma2}^2}} \\[2mm] n_{ny\gamma} = \dfrac{n_{y\beta2}}{\sqrt{n_{x\gamma2}^2 + n_{y\gamma2}^2 + n_{z\gamma2}^2}} \\[2mm] n_{nz\gamma} = \dfrac{n_{z\beta2}}{\sqrt{n_{x\gamma2}^2 + n_{y\gamma2}^2 + n_{z\gamma2}^2}} \end{cases}$$

Thus, the equation of the tooth surface of the second gear is obtained as follows:

$$\begin{cases} x_{\Sigma1} = n_{x\beta}x_c + n_{x\alpha}y_c + n_{x\gamma}z_c + x_{r1} \\ y_{\Sigma1} = n_{y\beta}x_c + n_{y\alpha}y_c + n_{y\gamma}z_c + y_{r1} \\ z_{\Sigma1} = n_{z\beta}x_c + n_{z\alpha}y_c + n_{z\gamma}z_c + z_{r1} \end{cases}$$

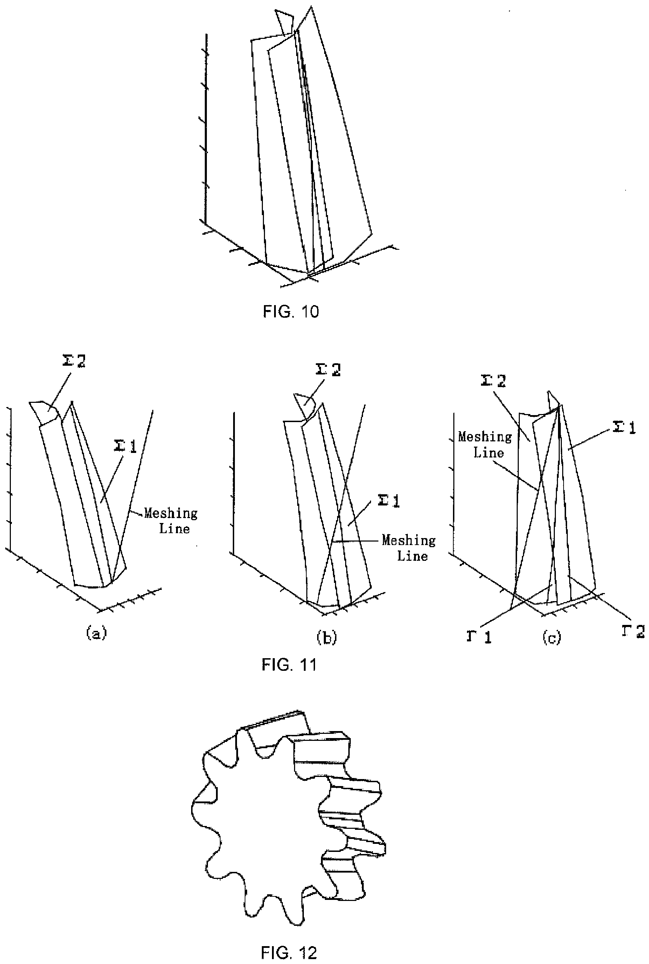

The constructed curved surface is shown in FIG. 10.

Further, the normal section has a circular arc or hyperbolic tooth profile.

Preferably, a circular arc or hyperbolic tooth profile is selected as the normal section in comprehensive consideration of the bearing capacity of the tooth surface and the machining convenience, and the circular arc tooth profile is taken as a research object in the present embodiment.

Further, the method further comprises a step vii of writing a program according to the equation of the tooth surface of the gear to solve the equation of the tooth surface.

After the equation of the tooth surface is obtained, a program is written using MATLAB to obtain a structural diagram of the tooth surface of the second gear, as shown in FIG. 10.

After the curve-curved surface meshing pair is constructed, the emulation of meshing is performed in MATLAB, as shown in FIG. 11. The specific parameters are shown in Table 1. FIG. 11(a) shows a starting point of the meshing, FIG. 11(b) shows an arbitrary position in the meshing, FIG. 11(c) shows an ending point of the meshing. It can be seen that the curve and the curved surface are always kept into point contact and are respectively meshed along the meshing line (curve), the meshing point is clearly visible, and a trajectory of the meshing point on the curved surface coincides with the obtained meshing trace.

Further, the method further comprises a step viii of calculating coordinates of points on the tooth surface according to the solved equation of the tooth surface, and importing the coordinates of the points on the tooth surface into three-dimensional software, and generating a solid model of a gear tooth by the three-dimensional software.

Then, the data points of the tooth surface are collected and imported into the three-dimensional design software UG (Unigraphics) on the basis of the gear design parameters in Table 1 to establish a function relational expression to constrain the dimensions of an addendum circle, a dedendum circle, a reference circle and the like, and a complete gear model is established by using functions such as curved surface molding, as shown in FIG. 12.

**Second Embodiment**

The present embodiment differs from the first embodiment in that an envelope method is used in the step vi to determine the equation of the tooth profile of the gear.

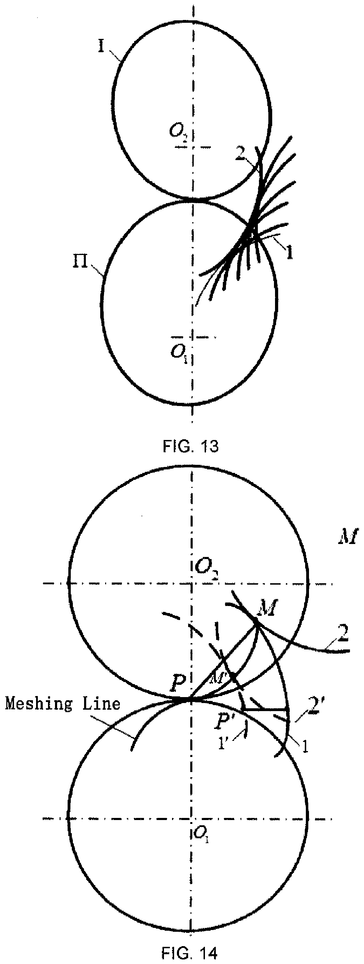

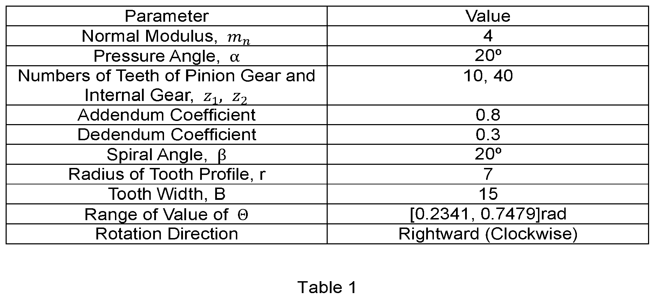

Specifically, as shown in FIG. 13, assuming that the gear 2 is fixed and unmovable and an instantaneous center line (curve) I is purely rolled on an instantaneous center line (curve) Π, the tooth profile 1 forms a family of curves on the plane of the gear 2. Since the tooth profile 2 and the tooth profile 1 are in tangential contact at each instant, the tooth profile 2 should be mathematically considered as an envelope of the family of curves formed by the tooth profile 1. With this principle, the tooth profile 2 can be obtained from the motion law of the gear pair and the tooth profile 1, and this method is called an envelope method.

The phenomenon in which the tooth profile of one gear envelops the tooth profile of the other gear can be observed clearly when the gears are machined by using a generating method, for example, if a tooth profile of a gear shaper cutter (including a side edge and a top edge) is used as the tooth profile 1 when the gear is being shaped, it gradually envelops the tooth profile 2 of the workpiece during the generating process.

**Third Embodiment**

The present embodiment differs from the first embodiment in that a tooth profile normal method is used in the step vi to determine the equation of the tooth profile of the gear.

Specifically, both the gears 1 and 2 are rotated. Assuming that the tooth profile 1 is located at a position shown by a solid line in FIG. 14 at a certain instant, a point M, having a normal passing an instantaneous center point P, can be obtained on the gear 1 according to the condition where $n \cdot v = 0$, then M is a contact point between the tooth profiles 1 and 2 at this instant. When the gear 1 is rotated by an angle and the tooth profile is rotated to a position shown by a broken line in FIG. 13, a point M' having a normal passing the point P can also be obtained, then M' is a contact point between the two tooth profiles at this instant. In this way, a series of contact point locations during the rotation of the gear 1 are obtained, and their trajectory in the fixed plane is called a meshing line (since the two tooth profiles are continuously meshed along this line). The trajectory of the contact point on the plane of the rotating gear 2 is the desired tooth profile 2.

The method for designing a geometric elements constructed tooth pair based on curve-surface conjugation according to the present disclosure is not limited to the involute gear, and the first gear and the second gear are brought into contact on the theoretical basis of curve-surface meshing, which has the characteristics of strong adaptability to the axis skew and pitch error of the gear and the separability of the center distance, and moreover, the actual contact between the first gear and the second gear is in a point contact state, and approximately theoretically pure rolling occurs between the tooth surfaces with a small rate of sliding; and the type of contact between the tooth surfaces is not limited to the convex-convex contact, or may also be convex-concave contact, and the present disclosure is applicable over a wide range and can improve the bearing capacity of the gears.

Finally, it should be noted that the above embodiments are merely intended to illustrate, but not limit, the technical solutions of the present disclosure; although the present disclosure has been described in detail with reference to the foregoing embodiments, those of ordinary skill in the art will understand that the technical solutions described in the foregoing embodiments may be modified, or some or all of the technical features thereof may be equivalently replaced; and these modifications or replacements will not cause the spirit of the corresponding technical solutions to deviate from the scope of the technical solutions of the embodiments of the present disclosure.

**Claims**

1. A geometric-elements-constructed tooth pair based on curve-surface conjugation, **characterized by** comprising a first gear and a second gear, wherein the first gear and the second gear form a gear pair of curve-surface conjugation;

   the gear pair of curve-surface conjugation comprises a curved surface ($\Sigma_1$) and a curve ($\Gamma_1$) which are in continuous tangential contact, the curved surface ($\Sigma_1$) is located on the first gear, and only one curve on the curved surface ($\Sigma_1$) is in contact with the curve ($\Gamma_1$); at a predetermined time, the curve ($\Gamma_1$) is kept into a point contact with the curved surface ($\Sigma_1$), and at the predetermined time, the curve ($\Gamma_1$) and the curved surface ($\Sigma_1$) have a unique contact point therebetween; and
   the curve ($\Gamma_1$) is smooth, and the curved surface ($\Sigma_1$) is smooth.

2. A method for designing a geometric-elements-constructed tooth pair based on curve-surface conjugation, **characterized by** comprising steps of:

   i) determining an equation of a curved surface ($\Sigma_1$) of a first gear as:

$$\begin{cases} X_{\Sigma 1} = X(u,v) \\ Y_{\Sigma 1} = Y(u,v) \\ Z_{\Sigma 1} = Z(u,v) \end{cases}$$

where u and v are parameters of the curved surface;

ii) determining an equation of a contact trace ($\Gamma_2$) on a tooth surface of the first gear as:

$$\begin{cases} X_{r2} = X(u(\varphi), v(\varphi)) \\ Y_{r2} = Y(u(\varphi), v(\varphi)) \\ Z_{r2} = Z(u(\varphi), v(\varphi)) \end{cases}$$

where $\varphi$ is a spatial parameter;

iii) determining a normal vector $n_2^{12}(\; n_{x2}\; ,\; n_{y2}\; ,\; n_{z2}\; )$ of the contact trace on the tooth surface of the first

$$\begin{cases} n_{x2} = \frac{\partial(y_2, z_2)}{\partial(u,v)} |_{u(\varphi), v(\varphi)} \\ n_{y2} = \frac{\partial(z_2, x_2)}{\partial(u,v)} |_{u(\varphi), v(\varphi)} \\ n_{z2} = \frac{\partial(x_2, y_2)}{\partial(u,v)} |_{u(\varphi), v(\varphi)} \end{cases}$$

gear as:

iv) determining a meshing equation of a curve ($\Gamma_1$) and the curved surface ($\Sigma_1$) based on a formula n·$v^{(12)}$ = 0;

$$\begin{cases} \Gamma_1^2(\varphi_1\; ,\; \varphi_2) = M_{12}(\varphi_2)\Gamma_2^2(\varphi) \\ f(\varphi_1\; ,\; \varphi_2) = v_2^{(12)} \cdot n_2^{12} = 0 \end{cases}$$

v) determining a conjugate curve according to an equation of the contact trace ($\Gamma_2$) in a fixed coordinate system ($S_1$) and the meshing equation; and

vi) determining an equation of a tooth surface ($\Sigma_2$) of a second gear according to the conjugate curve.

3. The method for designing a geometric-elements-constructed tooth pair based on curve-surface conjugation according to claim 2, wherein the step v further comprises steps of:

establishing the fixed coordinate system ($S_1$) and a moving coordinate system ($S_2$), wherein the fixed coordinate system ($S_1$) and the moving coordinate system ($S_2$) are fixedly associated with the curve ($\Gamma_1$) and the curved surface ($L_1$), respectively; and

determining a transformation matrix between the moving coordinate system ($S_2$) and the fixed coordinate system ($S_1$) as:

$$M_{12(\varphi_2)}$$
$$= \begin{bmatrix} \cos(\varphi_1 - \varphi_2) & \sin(\varphi_1 - \varphi_2) & 0 & -a\cos\varphi_1 \\ -\sin(\varphi_1 - \varphi_2) & \cos(\varphi_1 - \varphi_2) & 0 & a\sin\varphi_1 \\ 0 & 0 & 1 & 0 \\ 0 & 0 & 0 & 1 \end{bmatrix}$$

where $\varphi_1$ is an angle by which the curve ($\Gamma_1$) is rotated, and $\varphi_2$ is an angle by which the curved surface ($\Sigma_1$) is rotated.

4. The method for designing a geometric-elements-constructed tooth pair based on curve-surface conjugation according to claim 3, wherein the step iv further comprises:

determining a relative movement velocity $v^{(12)}$ of the moving coordinate system ($S_2$) with respect to the fixed coordinate system ($S_1$) as:

$$\begin{cases} v_x^{12} = \omega_2 y_2 - \omega_1 \left( y_2 + a\sin\varphi_2 \right) \\ v_y^{12} = \omega_1 (x_2 - a\cos\varphi_2) - \omega_2 x_2 \\ \qquad v_z^{12} = 0 \end{cases}$$

where $\omega_1$ is an angular velocity at which the curve ($\Gamma_1$) is rotated, and $\omega_2$ is an angular velocity at which the curved surface ($\Sigma_1$) is rotated.

5. The method for designing a geometric-elements-constructed tooth pair based on curve-surface conjugation according to claim 4, wherein the step vi further comprises:

selecting a curve of a normal section as $\Gamma_c$:

$$\Gamma_{(t)} = \left( \begin{array}{cccc} x(t) & 0 & z(t) & 1 \end{array} \right)^{T_r},$$

where x(t) and z(t) are functions of a parameter t;
the ($\Gamma_c$) is located on a normal plane of the curve ($\Gamma_1$) and intersects the curve ($\Gamma_1$) at a point, and the curve ($\Gamma_c$) passes the intersection point and a principle normal vector direction of the curve ($\Gamma_c$) at the intersection point is consistent with a principle normal direction of the curved surface ($\Sigma_1$) at the intersection point;

determining the equation of the tooth surface ($\Sigma_2$) as follows:

$$S\left( \varphi , t \right) = M_C \Gamma \left( t \right),$$

$$M_C = \begin{bmatrix} \beta_1^2 \cdot i_1 & \alpha_1^2 \cdot i_1 & \gamma_1^2 \cdot i_1 & \\ \beta_1^2 \cdot j_1 & \alpha_1^2 \cdot j_1 & \gamma_1^2 \cdot j_1 & \Gamma_1^2 \\ \beta_1^2 \cdot k_1 & \alpha_1^2 \cdot k_1 & \gamma_1^2 \cdot k_1 & \end{bmatrix}$$

**where** $\beta_1^2$ is a principle normal vector of the curved surface ($\Sigma_2$) at the intersection point, $\alpha_1^2$ is a vector tangent to the contact trace ($\Gamma_2$) on the curved surface ($\Sigma_2$) at the contact point, and $\gamma_1^2$ is obtained by $\beta_1^2 \times \alpha_1^2$.

FIG. 1

$\Sigma 1$

$\Gamma 2$

FIG. 2

$\Gamma 2$

FIG. 3

FIG. 4

(a)                    (b)

FIG. 5

FIG. 6

FIG. 7

FIG. 8

FIG. 9

FIG. 10

FIG. 11

FIG. 12

**FIG. 13**

**FIG. 14**

| Parameter | Value |
|---|---|
| Normal Modulus, $m_n$ | 4 |
| Pressure Angle, $\alpha$ | 20º |
| Numbers of Teeth of Pinion Gear and Internal Gear, $z_1$, $z_2$ | 10, 40 |
| Addendum Coefficient | 0.8 |
| Dedendum Coefficient | 0.3 |
| Spiral Angle, $\beta$ | 20º |
| Radius of Tooth Profile, r | 7 |
| Tooth Width, B | 15 |
| Range of Value of $\Theta$ | [0.2341, 0.7479]rad |
| Rotation Direction | Rightward (Clockwise) |

Table 1

## INTERNATIONAL SEARCH REPORT

| International application No. |
| --- |
| **PCT/CN2019/075539** |

**A. CLASSIFICATION OF SUBJECT MATTER**

F16H 55/08(2006.01)i

According to International Patent Classification (IPC) or to both national classification and IPC

**B. FIELDS SEARCHED**

Minimum documentation searched (classification system followed by classification symbols)

F16H

Documentation searched other than minimum documentation to the extent that such documents are included in the fields searched

Electronic data base consulted during the international search (name of data base and, where practicable, search terms used)

CNABS, VEN: 曲线, 齿轮副, 曲面, 共轭, 啮合, mesh, gear, pair, conjugate, curve, surface

**C. DOCUMENTS CONSIDERED TO BE RELEVANT**

| Category* | Citation of document, with indication, where appropriate, of the relevant passages | Relevant to claim No. |
| --- | --- | --- |
| PX | CN 109657388 A (CHONGQING UNIVERSITY) 19 April 2019 (2019-04-19)<br>entire document | 1-5 |
| A | CN 108679196 A (JIANGSU PACIFIC GEAR TRANSMISSION CO., LTD.; JIANGSU PACIFIC PRECISION FORGING CO., LTD.) 19 October 2018 (2018-10-19)<br>description, paragraphs [0039]-[0108], and figures 1-3 | 1-5 |
| A | CN 106126844 A (DALIAN JIAOTONG UNIVERSITY) 16 November 2016 (2016-11-16)<br>entire document | 1-5 |
| A | CN 103122971 A (XI'AN UNIVERSITY OF TECHNOLOGY) 29 May 2013 (2013-05-29)<br>entire document | 1-5 |
| A | CN 103089963 A (XI'AN UNIVERSITY OF TECHNOLOGY) 08 May 2013 (2013-05-08)<br>entire document | 1-5 |
| A | US 6178840 B1 (GENESIS PARTNERS, L.P.) 30 January 2001 (2001-01-30)<br>entire document | 1-5 |

☐ Further documents are listed in the continuation of Box C.    ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **02 September 2019** | **10 October 2019** |

| Name and mailing address of the ISA/CN | Authorized officer |
| --- | --- |
| **China National Intellectual Property Administration**<br>**No. 6, Xitucheng Road, Jimenqiao Haidian District, Beijing**<br>**100088**<br>**China** | |
| Facsimile No. **(86-10)62019451** | Telephone No. |

Form PCT/ISA/210 (second sheet) (January 2015)

**INTERNATIONAL SEARCH REPORT**
Information on patent family members

| International application No. |
|---|
| **PCT/CN2019/075539** |

| Patent document cited in search report | | | Publication date (day/month/year) | Patent family member(s) | | | Publication date (day/month/year) |
|---|---|---|---|---|---|---|---|
| CN | 109657388 | A | 19 April 2019 | None | | | |
| CN | 108679196 | A | 19 October 2018 | None | | | |
| CN | 106126844 | A | 16 November 2016 | CN | 106126844 | B | 05 July 2019 |
| CN | 103122971 | A | 29 May 2013 | CN | 103122971 | B | 18 November 2015 |
| CN | 103089963 | A | 08 May 2013 | CN | 103089963 | B | 30 September 2015 |
| US | 6178840 | B1 | 30 January 2001 | US | 6178840 | B2 | 30 January 2001 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201811616387